# EUROPÄISCHE PATENTSCHRIFT

(11) **EP 2 289 074 B1**
(45) Veröffentlichungstag und Bekanntmachung des Hinweises auf die Patenterteilung: **13.09.2017**
(21) Anmeldenummer: 09749756.4
(22) Anmeldetag: 14.05.2009
(51) Int. Cl.: H05K 1/02, H05K 1/03, H01C 7/10, H01C 7/12, H01C 1/084

(54) **ELEKTRISCHE BAUELEMENTANORDNUNG MIT EINEM VARISTOR UND EINEM HALBLEITERBAUELEMENT**
ELECTRIC COMPONENT ARRANGEMENT COMPRISING A VARISTOR AND A SEMICONDUCTOR COMPONENT
ENSEMBLE DE COMPOSANTS ÉLECTRIQUES COMPRENANT UNE VARISTANCE ET UN COMPOSANT SEMI-CONDUCTEUR

(30) Priorität: 21.05.2008 DE 102008024481
(43) Veröffentlichungstag der Anmeldung: 02.03.2011
(73) Patentinhaber: Epcos AG, 81669 München (DE)
(72) Erfinder: ENGEL, Günter, 8430 Leibnitz (AT); FEICHTINGER, Thomas, 8010 Graz (AT); PECINA, Axel, 8543 St. Martin (AT)
(74) Vertreter: Epping - Hermann - Fischer
(86) Internationale Anmeldenummer: PCT/EP2009/055861
(87) Internationale Veröffentlichungsnummer: WO 2009/141266

(56) Entgegenhaltungen:
- EP-A- 1 580 809
- EP-A- 1 858 033
- JP-A- 11 228 261

## Beschreibung

Es wird eine elektrische Bauelementanordnung beschrieben, die nach einer Ausführungsform wärmeableitende Mittel für ein Halbleiterbauelement umfasst.

Aus DE 10 2007 013 016 A1 und auch auch aus EP 1 580 809 A2 ist ein Varistorbauelement mit Wärmeleitern bekannt. Auf dem Varistorbauelement ist nach einer Ausführung eine lichtemittierende Diode angeordnet. Eine zu lösende Aufgabe besteht darin, wärmeableitende Mittel für ein elektrisches Bauelement in einer Anordnung anzugeben. Die Aufgabe wird erfindungsgemäß durch die Merkmale des Anspruchs 1 gelöst.

Es wird eine elektrische Bauelementanordnung angegeben, die ein Halbleiterbauelement und einen Varistorkörper aufweist, wobei der Varistorkörper zum Schutz des Halbleiterbauelements vor elektrostatischen Entladungen mit diesem vorzugsweise parallel kontaktiert ist. Als wärmeableitendes Mittel ist ein Träger vorgesehen, der eine gut wärmeleitende Keramik enthält und auf dem sowohl das Halbleiterbauelement als auch der Varistorkörper angeordnet sind. Der Träger dient somit als gemeinsamer, wärmeableitender Träger für das Halbleiterbauelement und den Varistorkörper. Die Bauelementanordnung bildet insgesamt eine sich selbst tragende Einheit. Im Folgenden wird der gemeinsame Träger auch als Wärmesenke bzw. gemeinsame Wärmesenke bezeichnet. Durch die separate Anordnung des Halbleiterbauelements und des Varistorkörpers auf der gemeinsamen Wärmesenke wird dem Halbleiterbauelement durch die Verschaltung des Halbleiterbauelements mit dem Varistorkörper Schutz vor Überspannungen, insbesondere vor elektrostatischen Entladungen, geboten, wobei das Halbleiterbauelement vorteilhafterweise selbst zu diesem Zweck nicht weitergebildet bzw. angepasst werden muss. Der Varistorkörper kann zum Zweck des bestmöglichen Schutzes vor Überspannungen eines mit dem Varistorkörper elektrisch gekoppelten Halbleiterbauelements ohne Berücksichtigung der Bauform des Halbleiterbauelements separat hergestellt bzw. entworfen werden. Die Funktion des Schutzes vor Überspannungen des Varistorkörpers darf somit ohne einer durch die Struktur des Halbleiterbauelements bedingten Einschränkung voll ausgeschöpft werden.

Gemäß einer Ausführungsform enthält die Wärmesenke eine gut wärmeleitende Keramik. Als geeignete Keramiken haben sich zum Beispiel Aluminiumnitrid, Siliziumkarbid, Hafniumoxid und Manganoxid herausgestellt. Die gut wärmeleitende Keramik kann als Matrix gebildet sein, in der ein gut wärmeleitender Füllstoff aufgenommen ist, wie zum Beispiel Metall. So sind nach einer Ausführungsform Metallpartikel als Füllstoff in der bereits gut wärmeleitenden keramischen Matrix der Wärmesenke enthalten. Diese Maßnahme erhöht die gesamte Wärmeleitfähigkeit der Wärmesenke noch weiter.

Die als Träger wirkende Wärmesenke ist nach einer Ausführungsform als Platte bzw. als starre Unterlage ausgeführt, auf die das Halbleiterbauelement und der Varistorkörper montiert sind.

Gemäß einer Ausführungsform der Bauelementanordnung sind das Halbleiterbauelement und der Varistorkörper mit auf der gemeinsamen Wärmesenke aufgebrachten elektrischen Leiterbahnen kontaktiert. Dabei kann Wärme nicht nur direkt vom Halbleiterbauelement und vom Varistorkörper zur Wärmesenke ableitet werden, sondern auch von den elektrischen Leiterbahnen. Die elektrischen Leiterbahnen können jeweils mehrfach richtungsändernde Verläufe aufweisen bzw. als flächige, geometrische Muster realisiert sein. Sie können mittels Siebdrucken auf die Wärmesenke aufgebracht werden.

Das Halbleiterbauelement weist nach einer Ausführungsform auf seiner auf der Wärmesenke liegenden Unterseite elektrische Außenkontakte auf, welche mit elektrischen Leiterbahnen auf der Wärmesenke kontaktiert sind. Dabei wird bevorzugt, dass die elektrischen Außenkontakte des Halbleiterbauelements als Lotkugeln, insbesondere als Flipchipkontaktierung ausgeführt sind. Derartige elektrische Außenkontakte erleichtern die Montage des Halbleiterbauelements auf der Wärmesenke erheblich.

Die Wärmesenke weist nach einer vorteilhaften Ausführungsform Durchkontaktierungen auf, welche beispielsweise mit gegebenenfalls auf der Wärmesenke aufgebrachten Leiterbahnstrukturen verbunden sind. So kann eine elektrische Kontaktierung des Halbleiterbauelements und / oder des Varistorkörpers durch die Wärmesenke beispielsweise zu einer Leiterplatte hindurchgeführt werden.

Die Wärmesenke kann darüber hinaus mehrere übereinander angeordnete Schichten umfassen, zwischen denen beispielsweise Leiterbahnen verlaufen, die auch mit Durchkontaktierungen der Wärmesenke verbunden sein könnten. Bei den Schichten kann es sich um dielektrische Schicht, insbesondere um gut wärmeleitende Keramikschichten handeln.

Gemäß einer bevorzugten Ausführungsform der Bauelementanordnung enthält der Varistorkörper ein Kompositmaterial, das zumindest aus einer Varistorkeramik und einem gut wärmeleitenden Material zusammengesetzt ist, wobei das gut wärmeleitende Material sich von der Varistorkeramik, die hauptsächlich zur nichtlinearen Widerstandsfunktion des Varistorkörpers gewählt ist, unterscheidet. Geeignete Rezepturen für eine Matrix sind beispielsweise die Verbindungen Zinkoxid - Wismut - Antimon oder Zinkoxid - Präseodym.

Gemäß einer Ausführungsform ist die Varistorkeramik als Hauptkomponente bzw. als Matrix des Kompositmaterials und das wärmeleitende Material als Füllstoff in dieser Matrix gebildet. Ein Beispiel eines gut wärmeleitenden Füllstoffs ist ein Metall.

Der Füllstoff liegt vorzugsweise als eine Verteilung von gut wärmeleitenden Partikeln im Varistorkörper vor. Geeignete Metalle bzw. Legierungen umfassen beispielsweise Wolfram, Palladium, Platin, Silber.

Ein vorzugsweise als Füllstoff in der Varistorkeramik vorliegendes Metall hat den Vorteil, dem Varistorkörper eine höhere Wärmeleitfähigkeit zu verleihen, so dass Wärme vom Varistorkörper selbst zur Wärmesenke abgeleitet werden kann. Auch kann über die elektrischen Anschlüsse zwischen dem Halbleiterbauelement und dem Varistorkörper laufende Wärme über den besonders wärmeleitfähig ausgeführten Varistorkörper zur Wärmesenke abgeleitet werden.

Vorteilhaft ist eine Ausführungsform, bei der der Varistorkörper eine gut wärmeleitende Keramik enthält, die sich von der Varistorkeramik unterscheidet bzw. eine höhere Wärmeleitfähigkeit aufweist, als die Varistorkeramik. Als geeignete Keramiken haben sich zum Beispiel Aluminiumnitrid, Siliziumkarbid, Hafniumoxid und Manganoxid herausgestellt, insbesondere auch deshalb, weil sie sich mit einer bevorzugten Varistorkeramik wie zum Beispiel Zinkoxid gut versintern lassen, ohne dass sich unerwünschte kristalline Unterbrechungen im Varistorkörper ausbilden. Die zusätzliche, gut wärmeleitende Keramik kann ähnlich wie beim Metall als Füllstoff in der als Matrix ausgeführten Varistorkeramik vorliegen.

Der Varistorkörper kann als Vielschichtvaristor mit einem Stapel von Varistorkeramikschichten und zumindest bereichsweise dazwischenliegenden Innenelektrodenschichten ausgeführt sein. Es wird bevorzugt, dass der Vielschichtvaristor ein gesintertes, monolithisches Vielschichtbauelement ist. Als Varistorkeramik der einzelnen Schichten wird vorzugsweise hauptanteilig Zinkoxid gewählt, wobei die Innenelektroden Silber, Palladium, Platin, Kupfer, Nickel oder eine Legierung dieser Materialien enthalten können.

Nach einer Ausführungsform können ein oder mehrere Schichten eines als Vielschichtvaristor ausgebildeten Varistorkörpers Zirkonoxid aufweisen. Dabei wird bevorzugt, dass zumindest die Grundschicht des Vielschichtvaristors, die auf der keramischen Wärmesenke liegt, Zirkonoxid enthält. Dadurch können die Einflüsse von Streukapazitäten des Vielschichtvaristors auf die keramische Wärmesenke und der gegebenenfalls auf der keramischen Wärmesenke vorhandenen Leiterbahnen reduziert werden. Auch die Deckschicht des Vielschichtvaristors könnte als eine Zirkonoxid enthaltene Schicht ausgeführt sein. Das könnte von Vorteil sein, wenn auf dem Varistorkörper ein weiteres Bauelement angeordnet ist, das von Streukapazitäten ungestört blieben soll.

Anstelle eines Vielschichtvaristors kann der Varistorkörper als Bulkvaristor ausgeführt sein. Dieser weist einen einzigen Varistorblock auf, an dessen Außenseite gegenpolige Außenkontakte vorhanden sind. Der Varistorblock ist im Innern jedoch frei von metallischen Schichten.

Gemäß einer Ausführungsform weist der Varistorkörper mehrere elektrische Anschlüsse auf, von denen zumindest ein erster elektrischer Anschluss das Halbleiterbauelement kontaktiert. Dieser elektrische Anschluss ist vorzugsweise als metallische Schicht auf dem Varistorkörper ausgeführt. Die metallische Schicht kann auf zumindest einem Bereich der Oberseite des Varistorkörpers aufgebracht sein, beispielsweise mittels Siebdrucken. Die elektrischen Anschlüsse sind vorzugsweise bondbar.

Die mehreren elektrischen Anschlüsse können mit einem Kontaktdraht und / oder mit einer Leiterbahn auf der Wärmesenke verbunden sein.

Gemäß einer Ausführungsform der Bauelementanordnung umfassen die mehreren elektrischen Anschlüsse des Varistorkörpers zumindest einen vom ersten elektrischen Anschluss separaten, zweiten elektrischen Anschluss, der den Varistorkörper nach außen kontaktiert, welches bedeutet, dass der Varistorkörper mit diesem zweiten elektrischen Anschluss mit einem vom Halbleiterbauelement getrennten zweiten elektrischen Potential verbunden ist. Es kann sich bei einem zweiten elektrischen Anschluss beispielsweise um einen Masseanschluss handeln. Dabei kann der zweite elektrische Anschluss mit einer Leiterbahn auf einer Leiterplatte kontaktiert sein.

Sowohl ein erster elektrischer Anschluss als auch ein zweiter elektrischer Anschluss können als metallische Schichten ausgeführt sein. Als metallische Schichten ausgeführte elektrische Anschlüsse des Varistorkörpers können zumindest eines der folgenden Materialien enthalten: Gold, Nickel, Chromium, Palladium, Zinn.

Gemäß einer Ausführungsform der Bauelementanordnung ist der zweite elektrische Anschluss, der den Varistorkörper nach außen kontaktiert, auf der Unterseite des Varistorkörpers, d.h., auf der der Montagefläche des Halbleiterbauelements senkrecht gegenüberliegenden Fläche, angeordnet. Der zweite elektrische Anschluss kann beispielsweise als Bondpad ausgeführt sein.

Nach einer Ausführungsform ist es vorgesehen, dass der zweite elektrische Anschluss vom ersten elektrischen Anschluss beabstandet auf der Oberseite des Varistorkörpers angeordnet ist. Dabei könnten beide Anschlüsse Kontaktdrähte umfassen, die den Varistorkörper mit dem Halbleiterbauelement bzw. mit der Masse verbinden.

Nach einer Ausführungsform ist es vorgesehen, dass der erste elektrische Anschluss des Varistorkörpers, der das Halbleiterbauelement kontaktiert, gleichzeitig einen Kontakt des Varistorkörpers nach außen bildet, gegebenenfalls unter Verwendung eines mit dem ersten elektrischen Anschluss verwendeten Kontaktdrahtes.

Gemäß einer Ausführungsform weist der Varistorkörper zumindest eine Innenelektrode auf, die zur Abstimmung der Kapazität des Varistorkörpers dienen kann. Die Innenelektrode kann zwischen den Schichten eines Schichtstapels angeordnet sein. Es kann sich bei der Innenelektrode um eine Masseelektrode handeln, welche Überspannungen bzw. Stoßströme durch den Varistor bzw. vom Varistorkörper ableitet. Die Innenelektrode ist mit zumindest einem elektrischen Anschluss des Varistorkörpers verbunden-- eine mechanische Kontaktierung ist dabei jedoch nicht zwingend erforderlich. Die Innenelektrode könnte daher im Innern des Varistorkörpers "schwebend" angeordnet sein. Alternativ ist die Innenelektrode mittels zumindest einer Durchkontaktierung, auch als Via zu bezeichnen, mit dem zumindest einen elektrischen Anschluss verbunden.

Gemäß einer Ausführungsform sind mehrere Innenelektroden im Varistorkörper vorhanden und kontaktieren unterschiedliche elektrische Anschlüsse des Varistorkörpers. Die Innenelektroden können schwebend oder nach außen kontaktiert ausgeführt sein. Es wird bevorzugt, dass sie mittels einer Varistorkeramik bzw. mittels eines Dielektrikums voneinander getrennt sind und in Stapelrichtung gemeinsame Überlappflächen aufweisen, durch die Kapazitäten erzeugbar sind. Die Innenelektroden verlaufen gemäß einer Ausführungsform senkrecht zur Montagefläche des Halbleiterbauelements.

Bevorzugt wird eine Bauelementanordnung mit einem Gehäuse in bzw. an dem die Wärmesenke angeordnet ist. Es wird bevorzugt, dass das Gehäuse zumindest einen elektrisch leitenden Teil oder Bereich aufweist, der mit dem Varistorkörper und / oder mit dem Halbleiterbauelement kontaktiert ist. Das Gehäuse trägt den Varistorkörper, wobei das Halbleiterbauelement und der Varistorkörper mit dem elektrisch leitenden Teil des Gehäuses parallel verschaltet sind. Der elektrisch leitende Teil des Gehäuses kann als metallische Schicht, beispielsweise als Leiterbahn ausgeführt sein. Der elektrisch leitende Teil des Gehäuses enthält vorzugsweise Aluminium oder Kupfer.

Gemäß einer Ausführungsform weist das Gehäuse zumindest einen wärmeleitenden Bereich auf, der thermisch mit dem gemeinsamen Träger bzw. der gemeinsamen Wärmesenke des Varistorkörpers und des Halbleiterbauelements gekoppelt ist. Dadurch kann vom Varistorkörper bzw. vom gemeinsamen Träger aufgenommene Wärme durch das Gehäuse abgeleitet werden. Dabei kann dieser wärmeleitende Bereich des Gehäuses ein gut wärmeleitendes Material, wie zum Beispiel eine gut wärmeleitende Keramik oder ein Metall aufweisen.

Gemäß einer günstigen Ausführungsform der Bauelementanordnung weist sie zusätzlich einen Thermistor auf, der mit dem Halbleiterbauelement verschaltet ist. In Abhängigkeit seiner Widerstands / Temperaturkennlinie trägt der Thermistor zur Regulierung des Steuerstroms des Halbleiterbauelements bei, sodass dieser schonend betrieben werden kann. Der Thermistor ist gemäß einer Ausführungsform auf dem Varistorkörper montiert, muss es aber nicht sein. Stattdessen könnte er auf dem gemeinsamen Träger bzw. der gemeinsamen Wärmesenke neben dem Varistorkörper angeordnet sein oder getrennt vom Träger in einem gemeinsamen Gehäuse. Der Thermistor kann mit einer Auswerteeinheit verbunden sein, die gemessene Werte des Thermistors verwendet um den das Halbleiterbauelement speisenden Strom zu regulieren. Die Regulierung des Steuerstroms erfolgt derart, dass die LED keinen Stoßströmen ausgesetzt wird bzw. unter möglichst konstantem Wechselstrom betrieben wird.

Das Halbleiterbauelement kann aus einer Vielzahl von Bauelementen gewählt sein. Es kann ein optoelektronisches Bauelement, wie z.B. eine LED, ein Kondensator bzw. ein Vielschichtkondensator, ein Thermistor bzw. ein Vielschichtthermistor mit PTC oder NTC Eigenschaften, eine Diode oder ein Verstärker sein. In jedem Falle ist der Varistorkörper in der Lage, das mit ihm kontaktierte Halbleiterbauelement vor Überspannungen schonend zu schützen und sogar nach einigen in diesem Dokument beschriebenen Ausführungsformen in der Lage, Wärme vom Halbleiterbauelement abzuleiten.

Eine LED als Halbleiterbauelement ist zusammengesetzt vorzugsweise aus einem oder mehreren der folgenden Materialien: Galliumphosphid (GaP), Galliumnitrid (GaN), Galliumarsenphosphid (GaAsP), Aluminiumgalliumindiumphosphid (AlGaInP), Aluminiumgalliumphosphid (AlGaP), Aluminiumgalliumarsenid (AlGaAs), Indiumgalliumnitrid (InGaN), Aluminiumnitrid (AlN), Aluminiumgalliumindiumnitrid (AlGaInN), Zinnselenid (ZnSe).

Die Bauelementanordnung mit der gemeinsamen keramischen Wärmesenke hat den Vorteil, als Einzelprodukt gewerblich verwertbar zu sein.

Die beschriebenen Gegenstände werden anhand der folgenden Ausführungsbeispiele und Figuren näher erläutert. Dabei zeigt:
- Figur 1: eine schematische Draufsicht auf eine Bauelementanordnung, bei der ein Halbleiterbauelement und ein Varistorkörper auf einer gemeinsamen Wärmesenke montiert sind und nach einem ersten Schema miteinander verschaltet sind,
- Figur 2: eine Querschnittsdarstellung des mit der Draufschicht in der Figur 1 gezeigten Varistorkörpers,
- Figur 3: eine schematische Draufsicht gemäß Figur 1, mit dem Unterschied, dass der Varistorkörper mittels mehrerer, unterseitiger Kontakte mit verschiedenen Leiterbahnen kontaktiert ist und zumindest eine Innenelektrode aufweist,
- Figuren 4 bis 6: verschiedene Ausführungsformen eines Varistorkörpers,
- Figur 7: eine perspektivische Ansicht einer Bauelementanordnung,
- Figur 8: eine Darstellung der Bauelementanordnung mit bzw. in einem Gehäuse.

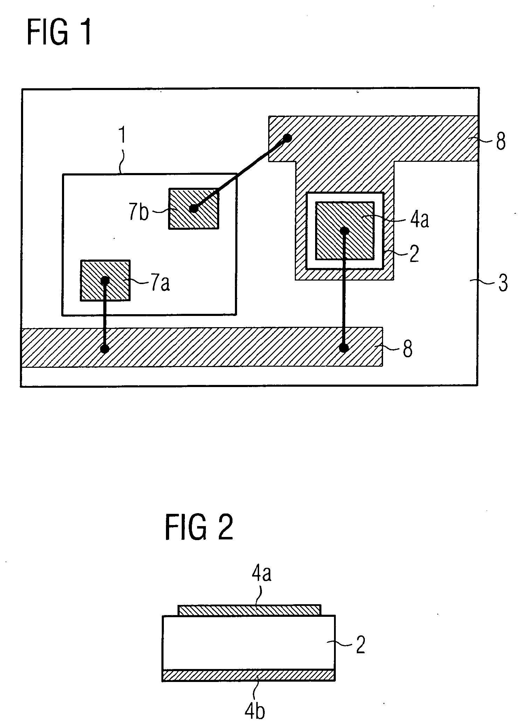

Figur 1 zeigt die Draufsicht auf eine optoelektronische Bauelementanordnung, bei der ein Halbeiterbauelement 1, hier eine LED, sowie ein Varistorkörper 2 voneinander getrennt auf einen gemeinsamen, wärmeleitenden keramischen Träger 3 angeordnet sind. Die LED weist in diesem Beispiel oberseitig einen Anodenschluss 7a und einen Masseanschluss 7b auf. Die Anschlüsse 7a und 7b umfassen jeweils einen Bondpad als auch einen Kontaktdraht, der mit einer auf der keramischen Wärmesenke aufgebrachten Leiterbahn 8 verbunden ist. Mit den Anschlüssen der LED 1 kontaktierte Leiterbahnen sind derart geformt, dass sie jeweils mit einem elektrischen Anschluss des Varistorkörpers 2 verbunden sind.

Der Varistorkörper 2 weist oberseitig einen ersten elektrischen Anschluss 4a auf, beispielsweise einen Anodenanschluss, der als Bondpad ausgeführt ist. Unterseitig weist der Varistorkörper einen zweiten elektrischen Anschluss 4b auf (in der Perspektive dieser Figur nicht sichtbar), beispielsweise ein Masseanschluss. Der mit der Leiterbahn 8 verbundene zweite elektrische Anschluss 4b des Varistorkörpers 2 kann als Bondpad oder vorzugsweise als Flipchipkontaktierung ausgeführt sein.

Figur 2 zeigt eine Querschnittsansicht des in Figur 1 gezeigten Varistorkörpers 2. Es werden der oberseitige erste elektrische Anschluss 4a als auch der unterseitige zweite elektrische Anschluss 4b, jeweils als Schicht, gezeigt. Der zweite elektrische Anschluss 4b ist vorzugsweise ein Masseanschluss. Ein Varistorkörper 2 bzw. Varistorchip weist nach einer bevorzugten Ausführungsform die folgenden Abmessungen auf:

| | |
|---|---|
| Länge: | 200 µm +/- 10% |
| Breite: | 200 µm +/- 10% |
| Dicke: | 100 µm +/- 10% |

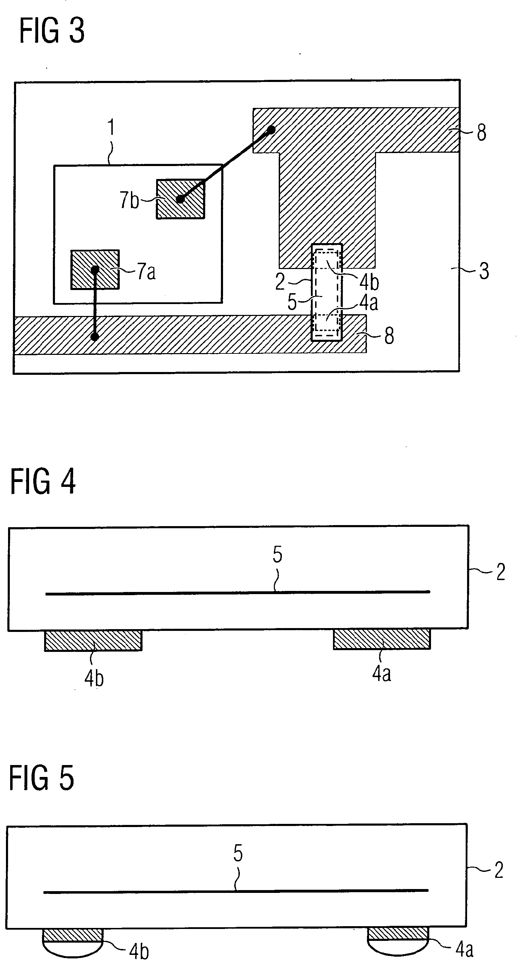

Figur 3 zeigt im Unterscheid zu Figur 1 einen Varistorkörper 2 mit unterseitig angebrachten, voneinander beabstandeten ersten 4a und zweiten 4b elektrischen Anschlüssen. Jeder dieser elektrischen Anschlüsse 4a und 4b ist mit einer Leiterbahn 8 kontaktiert. Die elektrischen Anschlüsse des Varistorkörpers 2 kontaktieren jedoch verschiedene, voneinander elektrisch isolierte Leiterbahnen. Über einen mittels einer im Varistorkörper enthaltenen Varistorkeramik erzeugten Varistorwiderstand und einer Innenelektrode 5 sind die elektrischen Anschlüsse 4a und 4b miteinander verbunden, wenn der Varistorkörper Überspannungen ausgesetzt bzw. elektrisch leitend wird. Hier wird zwar eine im Varistorkörper "schwebende" Innenelektrode 5 (gestrichelter Rahmen) gezeigt, jedoch ist diese nicht zwingend erforderlich. Die Anordnung von Innenelektroden 5 mit oder ohne mit diesen und elektrischen Anschlüssen kontaktierten Durchkontaktierungen wird bestimmt anhand der erforderlichen Spannungsgrenze, ab der der Varistorkörper elektrisch leitend wird um die Überspannung von bzw. zum Halbleiterbauelement abzuleiten.

Anstelle von unterseitig angebrachten elektrischen Anschlüssen 4a und 4b könnte der Varistorchip seitlich angebrachte elektrische Anschlüsse aufweisen. Vorzugsweise bilden die elektrischen Anschlüsse in jedem Fall jeweils eine geschlossene Schicht, beispielsweise aus Materialien enthaltend Nickel und / oder Zinn (Sn). Schichtdicken von als Schichten ausgeführten Außenkontakten eines Varistorkörpers bzw. Varistorchips können zwischen 0,9 und 3,1 µm liegen.

Figur 4 zeigt eine Querschnittsansicht des mit der Figur 3 in der Draufsicht gezeigten Varistorkörpers. Der Varistorkörper 2 umfasst einen Schichtstapel von varistorkeramischen Schichten, zwischen denen eine Innenelektrode 5 angeordnet ist. Auf der Unterseite des Varistorkörpers sind flächige Kontaktpads 4a und 4b angeordnet, die eine flächige Verbindung mit der jeweiligen Leiterbahn 8 auf der keramischen Wärmesenke 3 eingehen.

Figur 5 zeigt einen Varistorkörper 2 gemäß Figur 4 mit dem Unterschied, dass die unterseitig angebrachten Kontaktpads 4a und 4b jeweils aus einem ein Stück von der Unterseite des Varistorkörpers abstehenden, flächigen Kontaktpad und einem halbkugelförmigen Kontaktpad zusammengesetzt sind, die übereinander gesetzt sind. Die flächigen Kontaktpads sind dabei direkt auf den Varistorkörper aufgebracht und die halbkugelförmigen Kontaktpads auf die Unterseite des jeweiligen flächen Kontaktpads.

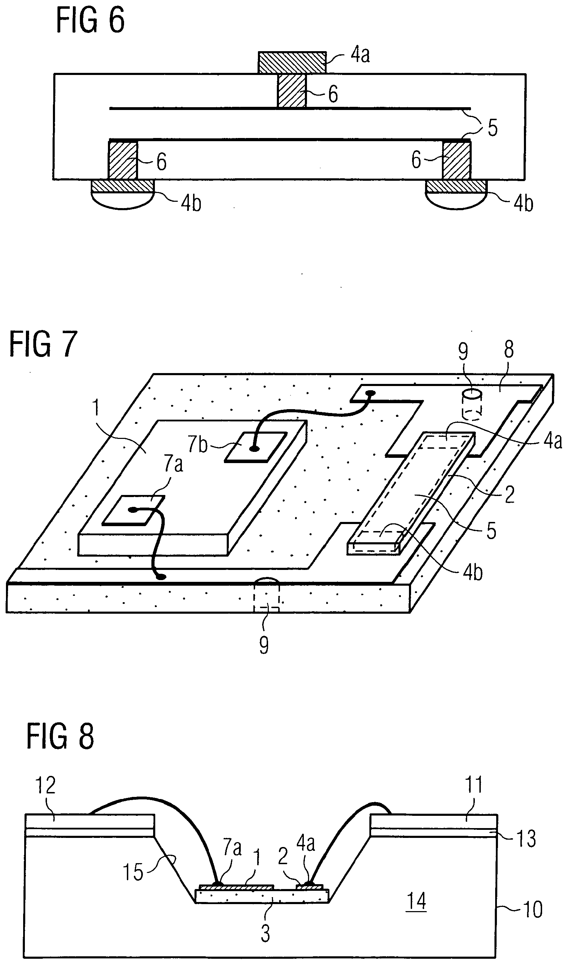

Figur 6 zeigt einen Varistorkörper 2, der oberseitig einen ersten elektrischen Anschluss 4a aufweist, beispielsweise in der Form eines ein Stück von der Oberseite des Varistorkörpers 2 abstehenden, flächigen Kontaktpads, der beispielsweise mittels eines Kontaktdrahtes entweder direkt oder indirekt mittels einer Leiterbahn 8 mit einem entsprechenden elektrischen, gleichpoligen Anschluss 7a des Halbleiterbauelements kontaktiert ist, z.B. ein Anodenanschluss. Bezüglich des Aufbaus der elektrischen Anschlüsse 4b auf der Unterseite des Varistorkörpers 2 unterscheidet sich der mit dieser Figur gezeigte Varistorkörper nicht von dem der vorhergehenden Figur. Allerdings können diese unterseitigen elektrischen Anschlüsse nach außen unterschiedlich kontaktiert sein. Beispielsweise könnten beide unterseitigen elektrischen Anschlüsse 4b mit einem Masseanschluss auf der keramischen Wärmesenke kontaktiert sein.

Die Figur 6 zeigt darüber hinaus Durchkontaktierungen 6, die senkrecht zur Ebene der keramischen Wärmesenke verlaufen und Innenelektroden 5 mit elektrischen Anschlüssen 4a bzw. 4b verbunden. Dabei verbindet eine erste Durchkontaktierung 6 einen oberseitigen elektrischen Anschluss 4a mit einer ersten Innenelektrode. Weitere Durchkontaktierungen 6 verbinden eine zweite Innenelektrode mit den mehreren unterseitigen elektrischen Anschlüssen 4b des Varistorkörpers 2. Die auf diese Art unterschiedlich mit Durchkontaktierungen verbundenen Innenelektroden sind voneinander mittels einer Varistorkeramik entkoppelt. Eine Innenelektrode 5 eines ersten elektrischen Pols soll also nur dann eine elektrische Verbindung mit einer Innenelektrode 5 eines zweiten Pols eingehen, wenn die zwischen ihnen vorhandene Varistorkeramik elektrisch leitend wird.

Die Durchkontaktierungen 6 können als mit einem elektrisch leitenden Material, beispielsweise Metall, gefüllte Bohrungen gebildet sein.

Sämtliche hier dargestellte Ausführungsformen von Varistorkörpern können ein Kompositmaterial aus einer Varistorkeramik als Matrix sowie einen gut wärmeleitenden Füllstoff, beispielsweise Metallkügelchen bzw. Metallpartikeln aufweisen. Sofern es sich um einen Vielschichtvaristorkörper handelt, kann zumindest eine Schicht oder mehrere Schichten den gut wärmeleitenden Füllstoff enthalten.

Figur 7 zeigt eine optoelektronische Bauelementanordnung in einer perspektivischen Ansicht. Neben der schematisch mit der Figur 3 dargestellten Verschaltung zwischen den elektrischen Bauelementen der Anordnung werden Durchkontaktierungen 9 gezeigt, welche die auf der keramischen Wärmesenke aufgedruckten Leiterbahnen 8 mit einer weiteren Leiterplatte (nicht gezeigt) oder einer externen elektrischen Schaltungsanordnung elektrisch verbinden können.

Figur 8 zeigt eine optoelektronische Bauelementanordnung einer in diesem Dokument zuvor beschriebenen Ausführungsform, wobei die Bauelementanordnung zusätzlich ein Gehäuse 10 mit einer Vertiefung bzw. Grube 15 aufweist. Auf dem Boden dieser Vertiefung liegt die keramische Wärmesenke 3. Diese kann eine oder mehrere Durchkontaktierungen 9 aufweisen, welche einen Masseanschluss des Varistorkörpers 2 mit einem Masseanschluss 14 des Gehäuses verbinden. Alternativ kann die keramische Wärmesenke 3 derart mit einer Leiterbahn 8 bedruckt sein, dass diese den Masseanschluss des Varistorkörpers 2 mit dem Masseanschluss 14 des Gehäuses verbindet.

Ein auf der keramischen Wärmesenke 3 aufgebrachtes Halbleiterbauelement 1 ist oberseitig mittels eines Kontaktdrahtes mit einem ersten elektrisch leitenden Teil 12 des Gehäuses verbunden. Oberseitig ist der Varistorkörper 2 mittels Kontaktdrahtes mit einem zweiten elektrisch leitenden Teil 13 des Gehäuses verbunden. Der erste, zweite sowie als Masseanschluss 14 dienende, elektrische leitende dritte Teil des Gehäuses 10 sind mittels einer Isolierung 13 voneinander elektrisch entkoppelt.

Wo es sich beim Halbleiterbauelement um eine LED handelt, ist es günstig, wenn die Vertiefung 15 auf ihrer dem Licht der LED exponierten Oberfläche eine reflektive Beschichtung aufweist. Dadurch kann die gesamte Lichtauskopplung von der Bauelementanordnung vergrößert werden. Der als Masse dienende, elektrisch leitende Teil des Gehäuses 14 kann beispielsweise aus einem Metall wie z.B. Kupfer oder Aluminium bestehen. Es wird insbesondere ein Metall bevorzugt, dass mit geringem Widerstand elektrisch leitend ist und eine hohe Reflektivität für eine verbesserte Lichtauskopplung aufweist.

Vorzugsweise ist der Varistorkörper 2 die gemeinsame Wärmesenke des Varistorkörpers 2 und des Halbleiterbauelements 1 mit einem gut wärmeleitenden Bereich des Gehäuses mechanisch verbunden, in jedem Fall jedoch thermisch mit ihm gekoppelt, damit das Gehäuse 10 von der gemeinsamen Wärmesenke aufgenommene Wärme, welche vom Varistorkörper 2 und / oder vom Halbleiterelement 1 stammt bzw. von diesen abgegeben wird, weiter nach außen ableiten kann.

### Bezugszeichenliste

- 1: Halbleiterbauelement
- 2: Varistorkörper
- 3: Träger bzw. Wärmesenke
- 4a: erster elektrischer Anschluss des Varistorkörpers
- 4b: zweiter elektrischer Anschluss des Varistorkörpers
- 5: Innenelektrode im Varistorkörper
- 6: Durchkontaktierung des Varistorkörpers
- 7a: erster elektrischer Anschluss des Halbleiterbauelements
- 7b: zweiter elektrischer Anschluss des Halbleiterbauelements
- 8: Leiterbahn auf bzw. im Träger
- 9: Durchkontaktierung des Trägers
- 10: Gehäuse
- 11: erster elektrisch leitender Teil des Gehäuses
- 12: zweiter elektrisch leitender Teil des Gehäuses
- 13: Isolierschicht
- 14: dritter elektrisch leitender Teil des Gehäuses

## Patentansprüche

1. Elektrische Bauelementanordnung, aufweisend ein Halbleiterbauelement (1) und einen Varistorkörper (2), der zum Schutz des Halbleiterbauelements vor elektrostatischen Entladungen mit diesem kontaktiert ist, **dadurch gekennzeichnet, dass** das Halbleiterbauelement und der Varistorkörper voneinander getrennt auf einem gemeinsamen Träger (3) angeordnet sind, der eine wärmeleitende Keramik enthält.

2. Bauelementanordnung nach Anspruch 1, bei der die wärmeleitende Keramik des Trägers (3) zumindest eines der Materialien Aluminiumnitrid, Galliumnitrid, Siliziumkarbid, Hafniumoxid, Manganoxid umfasst.

3. Bauelementanordnung nach einem der Ansprüche 1 oder 2, bei der der Träger (3) als Matrix die wärmeleitende Keramik und als Füllstoff ein Metall enthält.

4. Bauelementanordnung nach einem der vorhergehenden Ansprüche, bei der Träger (3) als Platte ausgeführt ist.

5. Bauelementanordnung nach einem der vorhergehenden Ansprüche, bei der der Träger (3) voneinander elektrisch entkoppelte Leiterbahnen (8) aufweist.

6. Bauelementanordnung Anspruch 5, bei der das Halbleiterbauelement (1) und der Varistorkörper (2) mit den Leiterbahnen (8) kontaktiert sind.

7. Bauelementanordnung nach einem der Ansprüche 5 oder 6, bei der der Varistorkörper (2) elektrische Außenkontakte (3a, 3b) auf seiner dem Träger (3) zugewandten Seite aufweist, die zumindest eine Leiterbahn (8) kontaktieren.

8. Bauelementanordnung nach einem der vorhergehenden Ansprüche, bei der der Varistorkörper (2) mit dem Halbleiterbauelement (1) parallel verschaltet ist.

9. Bauelementanordnung nach einem der vorhergehenden Ansprüche, bei der der Varistorkörper (2) zumindest eine Innenelektrode (5) aufweist.

10. Bauelementanordnung nach einem der vorhergehenden Ansprüche, bei der der Varistorkörper (2) zumindest einen elektrischen Außenkontakt (4a, 4b) sowie zumindest eine Innenelektrode (5) aufweist, wobei die Innenelektrode mittels zumindest einer Durchkontaktierung (6) mit dem Außenkontakt verbunden ist.

11. Bauelementanordnung nach einem der vorhergehenden Ansprüche, bei der der Varistorkörper (2) ein Kompositmaterial enthält, das zumindest aus einer Varistorkeramik als Matrix und einem wärmeleitenden Material als Füllstoff zusammengesetzt ist.

12. Bauelementanordnung nach einem der vorhergehenden Ansprüche, bei der der Träger (3) mit dem auf ihm montierten Halbleiterbauelement (1) und dem Varistorkörper (2) in einem Gehäuse (10) integriert ist, wobei das Gehäuse ein mit dem Träger verbundenen, wärmeleitenden Bereich aufweist, der mit dem Träger thermisch gekoppelt ist.

13. Bauelementanordnung nach einem der vorhergehenden Ansprüche, bei dem der Varistorkörper (2) einen monolithischen Vielschichtvaristor umfasst.

14. Bauelementanordnung nach einem der vorhergehenden Ansprüche, bei dem das Halbleiterbauelement (1) gewählt ist aus den Bauelementen: optoelektronisches Bauelement, LED, Kondensator, Vielschichtkondensator, Thermistor, Vielschichtthermistor, Diode, Verstärker.

15. Bauelementanordnung nach einem der vorhergehenden Ansprüche, zusätzlich aufweisend einen Thermistor, der in Abhängigkeit seiner Widerstands / Temperaturkennlinie zur Regulierung des Steuerstroms des Halbleiterbauelements (1) beiträgt.

## Claims

1. Electric component arrangement, comprising a semiconductor component (1) and a varistor body (2), which is contact-connected to the semiconductor component in order to protect the latter against electrostatic discharges, **characterized in that** the semiconductor component and the varistor body are arranged separately from one another on a common carrier (3) containing a thermally conductive ceramic.

2. Component arrangement according to Claim 1, wherein the thermally conductive ceramic of the carrier (3) comprises at least one of the materials aluminum nitride, gallium nitride, silicon carbide, hafnium oxide, manganese oxide.

3. Component arrangement according to either of Claims 1 and 2, wherein the carrier (3) contains the thermally conductive ceramic as matrix and a metal as filler.

4. Component arrangement according to any of the preceding claims, wherein the carrier (3) is embodied as a plate.

5. Component arrangement according to any of the preceding claims, wherein the carrier (3) has conductor tracks (8) that are electrically decoupled from one another.

6. Component arrangement Claim 5, wherein the semiconductor component (1) and the varistor body (2) are contact-connected to the conductor tracks (8).

7. Component arrangement according to either of Claims 5 and 6, wherein the varistor body (2) has external electrical contacts (3a, 3b), on its side facing the carrier (3), which make contact with at least one conductor track (8).

8. Component arrangement according to any of the preceding claims, wherein the varistor body (2) is connected in parallel with the semiconductor component (1).

9. Component arrangement according to any of the preceding claims, wherein the varistor body (2) has at least one internal electrode (5).

10. Component arrangement according to any of the preceding claims, wherein the varistor body (2) has at least one external electrical contact (4a, 4b) and also at least one internal electrode (5), wherein the internal electrode is connected to the external contact by means of at least one plated through-hole (6).

11. Component arrangement according to any of the preceding claims, wherein the varistor body (2) contains a composite material composed at least of a varistor ceramic as matrix and a thermally conductive material as filler.

12. Component arrangement according to any of the preceding claims, wherein the carrier (3) with the semiconductor component (1) and the varistor body (2) mounted on it is integrated in a housing (10), wherein the housing has a thermally conductive region which is connected to the carrier and which is thermally coupled to the carrier.

13. Component arrangement according to any of the preceding claims, wherein the varistor body (2) comprises a monolithic multilayer varistor.

14. Component arrangement according to any of the preceding claims, wherein the semiconductor component (1) is chosen from the components: optoelectronic component, LED, capacitor, multilayer capacitor, thermistor, multilayer thermistor, diode, amplifier.

15. Component arrangement according to any of the preceding claims, additionally comprising a thermistor which contributes, in a manner dependent on its resistance/temperature characteristic curve, to the regulation of the control current of the semiconductor component (1).

## Revendications

1. Ensemble de composants électriques, présentant un composant semi-conducteur (1) et un corps de varistance (2), lequel est mis en contact avec ledit composant semi-conducteur en vue de la protection de ce dernier contre les décharges électrostatiques, **caractérisé en ce que** le composant semi-conducteur et le corps de varistance sont disposés sur un support (3) commun, tout en étant séparés l'un de l'autre, lequel support contient une céramique conductrice de chaleur.

2. Ensemble de composants selon la revendication 1, pour lequel la céramique conductrice de chaleur du support (3) comprend tout au moins l'un des matériaux suivants : du nitrure d'aluminium, du nitrure de gallium, du carbure de silicium, de l'oxyde de hafnium, de l'oxyde de manganèse.

3. Ensemble de composants selon l'une des revendications 1 ou 2, pour lequel le support (3) contient la céramique conductrice de chaleur qui se présente sous la forme d'une matrice, ainsi qu'un métal qui se présente sous la forme d'une matière de remplissage.

4. Ensemble de composants selon l'une des revendications précédentes, pour lequel le support (3) est réalisé sous la forme d'une plaque.

5. Ensemble de composants selon l'une des revendications précédentes, pour lequel le support (3) présente des pistes conductrices (8), lesquelles sont découplées électriquement les unes par rapport aux autres.

6. Ensemble de composants la revendication 5, pour lequel le composant semi-conducteur (1) et le corps de varistance (2) sont mis en contact avec les pistes conductrices (8).

7. Ensemble de composants selon l'une des revendications 5 ou 6, pour lequel le corps de varistance (2) présente des contacts externes (3a, 3b) électriques sur une face orientée vers le support (3), lesquels contacts externes mettent en contact tout au moins une piste conductrice (8).

8. Ensemble de composants selon l'une des revendications précédentes, pour lequel le corps de varistance (2) est connecté en parallèle avec le composant semi-conducteur (1).

9. Ensemble de composants selon l'une des revendications précédentes, pour lequel le corps de varistance (2) présente tout au moins une électrode intérieure (5).

10. Ensemble de composants selon l'une des revendications précédentes, pour lequel le corps de varistance (2) présente tout au moins un contact externe (4a, 4b) électrique, ainsi que tout au moins une électrode intérieure (5), dans lequel l'électrode intérieure est reliée avec le contact externe au moyen de tout au moins une mise en contact transversale (6).

11. Ensemble de composants selon l'une des revendications précédentes, pour lequel le corps de varistance (2) contient un matériau composite, lequel est tout au moins composé à partir d'une céramique de varistance, laquelle se présente sous la forme d'une matrice, et d'un matériau conducteur de chaleur, lequel se présente sous la forme d'une matière de remplissage.

12. Ensemble de composants selon l'une des revendications précédentes, pour lequel le support (3) est intégré dans un boîtier (10), avec le composant semi-conducteur (1) qui est installé sur ledit support (3) et avec le corps de varistance (2), dans lequel le boîtier présente une zone conductrice de chaleur qui est reliée avec le support, laquelle zone est couplée de manière thermique avec le support.

13. Ensemble de composants selon l'une des revendications précédentes, pour lequel le corps de varistance (2) comprend une varistance monolithique à couches multiples.

14. Ensemble de composants selon l'une des revendications précédentes, pour lequel le composant semi-conducteur (1) est sélectionné parmi les éléments de structure suivants : un composant optoélectronique, une diode électroluminescente (DEL), un condensateur, un condensateur à couches multiples, un thermistor, un thermistor à couches multiples, une diode, un amplificateur.

15. Ensemble de composants selon l'une des revendications précédentes, présentant en outre un thermistor, lequel contribue à la régulation du courant de commande du composant semi-conducteur (1) en fonction de sa caractéristique de résistance / température.
